# EUROPEAN PATENT APPLICATION

(11) **EP 3 352 379 A1**
(43) Date of publication of application: **25.07.2018**
(21) Application number: 18153072.6
(22) Date of filing: 23.01.2018
(51) Int. Cl.: H04B 1/3827, H04M 1/04

(54) **SHIELD BRACKET OF ELECTROMAGNETIC WAVES FOR COMMUNICATION DEVICES**

(30) Priority: 23.01.2017 AR M170100173 U
(71) Applicant: Grupo Iron Bridge S.A., 8000 Bahia Blanca (Buenos Aires) (AR)
(72) Inventor: CABARCOS, David, 8000 BAHÍA BLANCA (BUENOS AIRES) (AR)
(74) Representative: Ruo, Alessandro

(57) **Abstract**

The shield bracket refers to a shield bracket of open enclosure (2) delimited by a support structure (1) equipped with a main wall of support (3) and a containment structure (4), which is prepared to receive and serve as a support for communication devices (100), such as cell phones; the entire structure (1) or at least its walls of side screen (5), which are projected beyond the open enclosure (2), are structured in aluminum and therefore constitute barriers to the emission of electromagnetic waves coming from the devices (100) which support. Thus, this limits the emission zone (Z1) of these electromagnetic waves issued by the device of communication (100) and creates a wide area of the protection zone (Z2).

## Description

### Field of the invention

This utility model relates to the field of the brackets with protection shields for devices that issue electromagnetic waves.

More particularly, it consists of a shield bracket of electromagnetic waves for communication devices which structure allows you to supported devices such as cell phones and blocks the issuance of the aforementioned waves toward the greater part of the surrounding area.

### Prior Art

As it is well known, there are various studies and opinions that warn over the possible harmful effects that radiation poses at lower scale on human health. While the conclusions of the studies do not coincide, agencies such as the World Health Organization (WHO) recommends taking precautions in this regard.

In this regard, it has been alerted about possible effects that may have exposure to the issuance of devices such as cell phones. Beyond the conclusions to which they have arrived through various ongoing investigations, the WHO has made a number of recommendations, among others, the adoption of simple measures of protection such as the presence of barriers around the sources of intense electromagnetic fields. This will help to decrease exposure.

However, until the present time, there are no known simple devices, simple and easy to use that serve to help towards the above-mentioned protection. Only some receptacles such as the one disclosed by the patent document CN202365064, which shows a portable receptacle, holster, with semi cylindrical walls that include a metallic mesh for protection.

Up to now there is no known protective bracket in which a cell phone can be merely supported for, and at the same time that serves as support, allows to block the issuance of waves toward your surrounding area.

### Advantages and purposes

A goal of this shield bracket is to provide a support site in which devices, such as a cell phone can be supported. Such is the case of fixed locations such as nightstand tables, desks, tables in general, shelves, coffee tables, etc. It is also the case of means of transport such as cars and other vehicles where the user is at a shorter distance from your phone.

An advantage of this support is that its support structure is simple and is combined with the presence of side screen walls that extend longitudinally by the side edges of the main wall of support, thus increasing the adjacent side of the protection zone.

Another advantage is the possibility of equipping the walls of side screen of a certain inclination that, without substantially affecting the protection zone adjacent to it, allows you to easily manipulate the sending device, both to place it in and out of the bearing bracket.

Another advantage is the simplicity of its structure based on a main wall of support, legs of different heights that determine the inclination or tilt, a containment structure for the lower support and walls erected at screen sideways.

Another advantage is the possibility of a structure from a laminar sheet cut and formed with lines of fold.

Another advantage of this support is that, both by its constitutional structural nature, such as the use of aluminum on its walls, it is extremely lightweight and easy to carry.

Another advantage is that the wall of complementary support can have a passage connection for the entry of a power cord, thus allowing to charge the batteries of the supported device.

### Illustration

For clarity and understanding of the utility model, it is illustrated with several figures in which it has been represented in one of their preferred form of realization, everything to simple title of illustrative example, but not limited to:

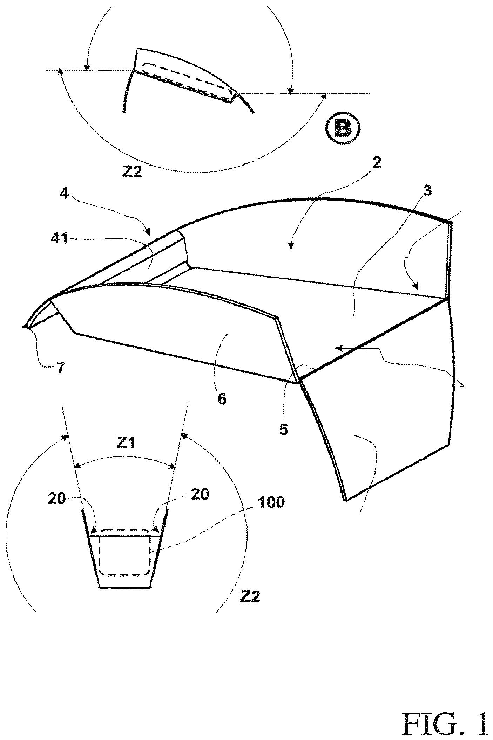

Figure 1 includes the drawings A, B, and C, being:
   The drawing A, a subsequent perspective view of this shield bracket of emission of electromagnetic waves, in a form of realization in the open the enclosure is bounded by the walls of side screen, the main wall of support and the extreme edge of complementary support;
   The drawing B, a detail with a side view in elevation of this shield bracket; and
   The drawing C, another detail with a rear view, in elevation, of this shield bracket indicating the protection zones and areas of emission of electromagnetic waves.
Figure 2 is a view in previous perspective of this shield bracket.
Figure 3 is a side view in elevation, of this shield bracket that allows you to appreciate side profile and shape of its walls side screen.
Figure 4 is a top view, on the ground, of this shield bracket which shows the layout of the different walls from the main wall of support.
Figure 5 is a side view in elevation, of this shield bracket side screen walls added.
Figure 6 is a longitudinal cut of this shield bracket, according to a cutting plane which has been indicated as VI-VI in figure 4.
Figure 7 is a back view in elevation of this shield bracket.
Figure 8 is a previous view in previous perspective in elevation of this shield bracket. - Figure 9 includes the drawings A, B, and C, being:
   The drawing A, a subsequent perspective view of this shield bracket of emission of electromagnetic waves, in a form of realization in which its edge of support comprises a passage of connection;
   The drawing B, a detail with a side view in elevation of this shield bracket; and
   The drawing C, another detail with a rear view, in elevation, of this shield bracket indicating the protection zones and areas of emission of electromagnetic waves.

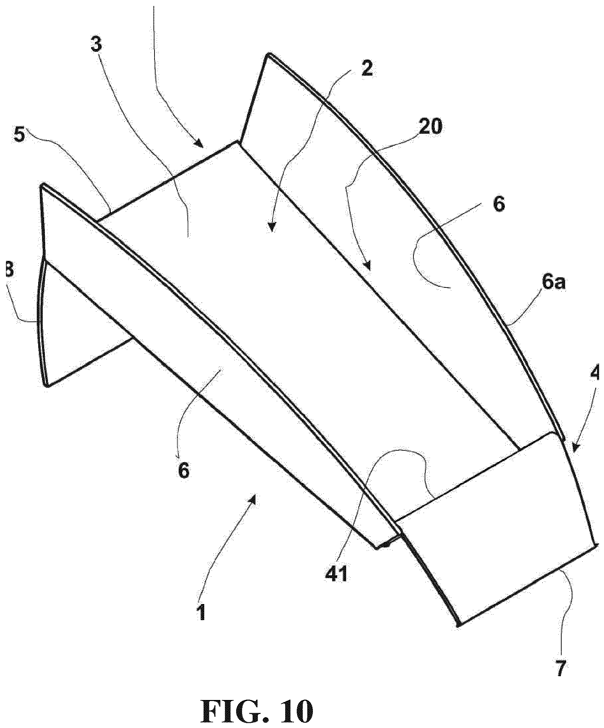

Figure 10 is a view in previous perspective of this shield bracket.

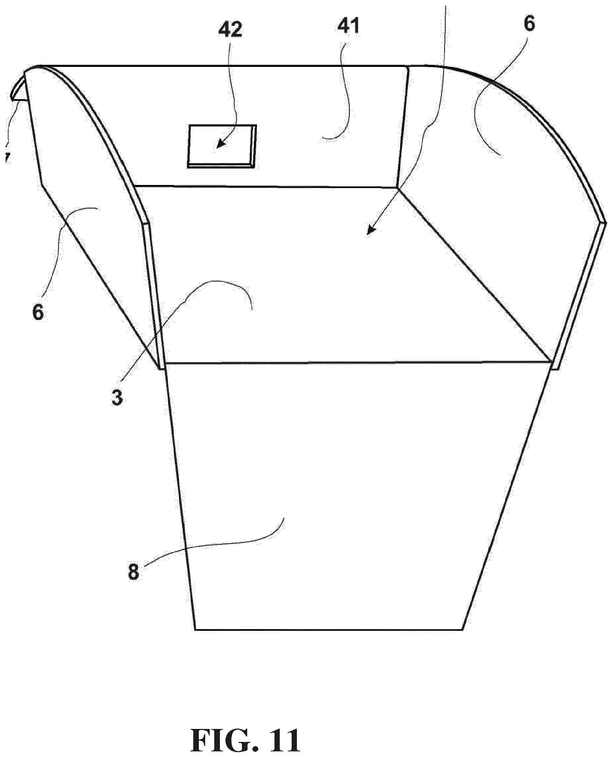

Figure 11 is a top view, on the ground, of this shield bracket which shows the layout of the different walls from the main wall of support.

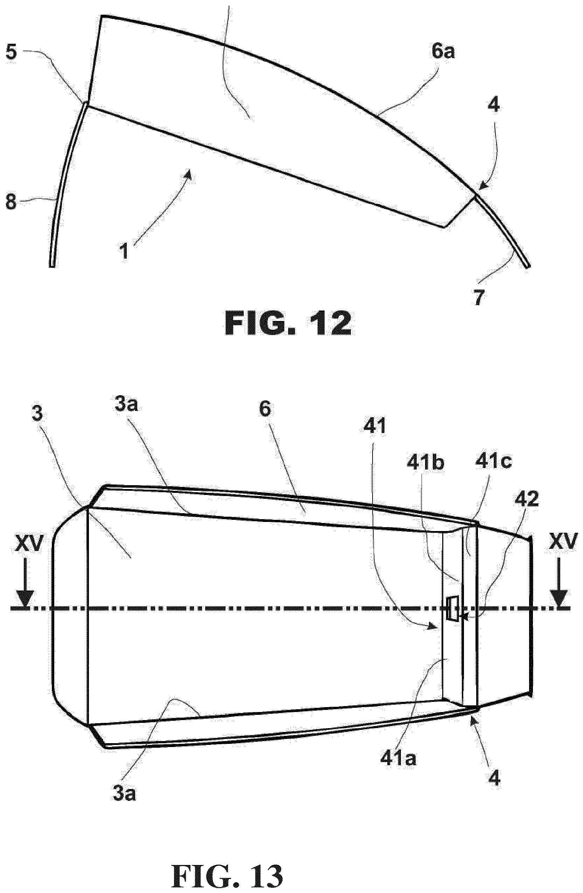

Figure 12 is a side view in elevation, of this shield bracket that allows you to appreciate your side profile and shape of its walls side screen.
Figure 13 is a top view, on the ground, of this shield bracket which shows the layout of the different walls from the main wall of support

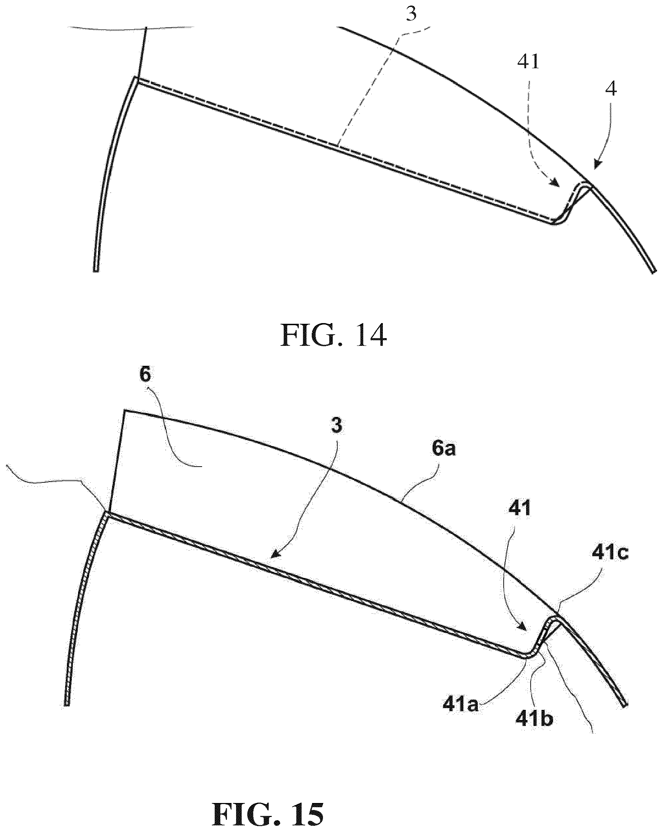

Figure 14 is a side view in elevation, of this shield bracket side screen walls added.
Figure 15 is a longitudinal cut of this shield bracket, according to a cutting plane which has been indicated as XV-XV in figure 13.

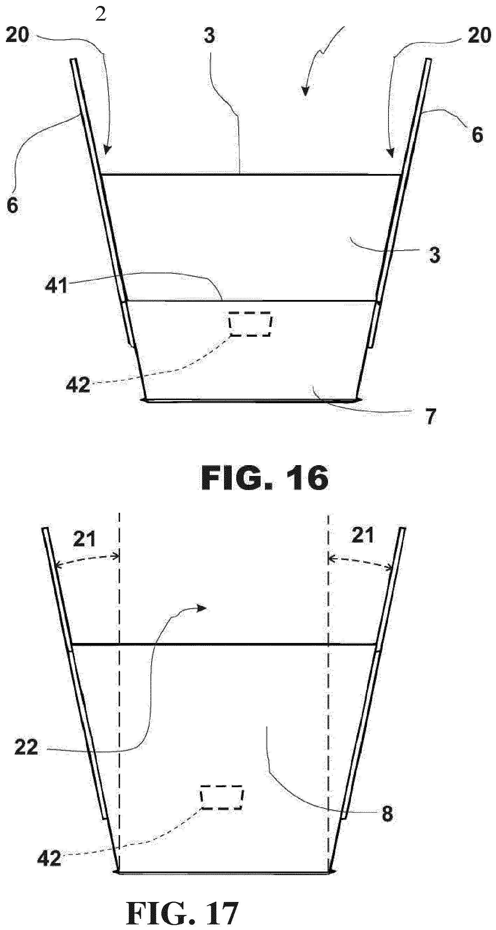

Figure 16 is a back view in elevation of this shield bracket.

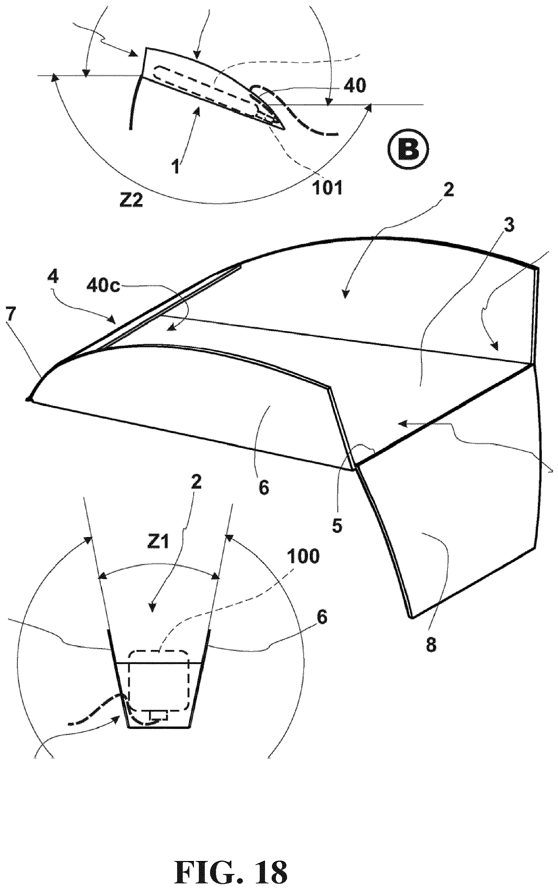

Figure 17 is a previous view in previous perspective in elevation of this shield bracket. Figure 18 includes the drawings A, B, and C, being:
   The drawing A, a subsequent perspective view of this shield bracket of emission of electromagnetic waves, in a form of realization in which its edge of support comprises a passage of connection;
   The drawing B, a detail with a side view in elevation of this shield bracket; and
   The drawing C, another detail with a rear view, in elevation, of this shield bracket indicating the protection zones and areas of emission of electromagnetic waves.

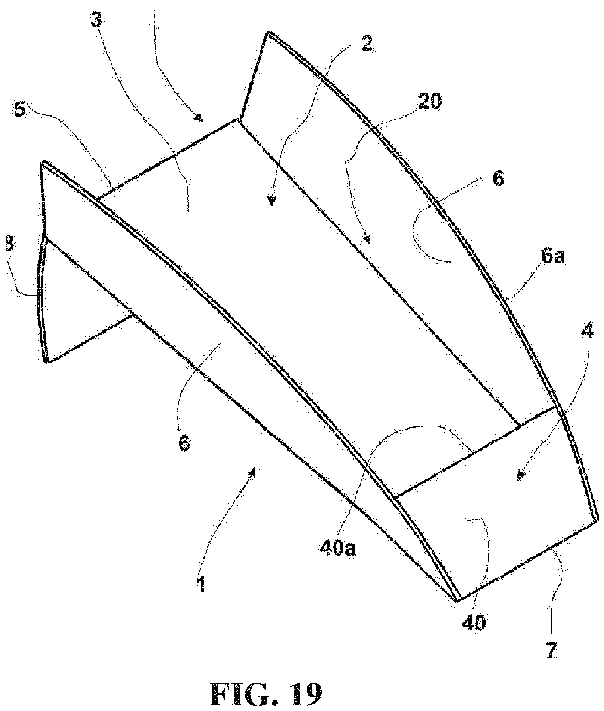

Figure 19 is a view in previous perspective of this shield bracket.

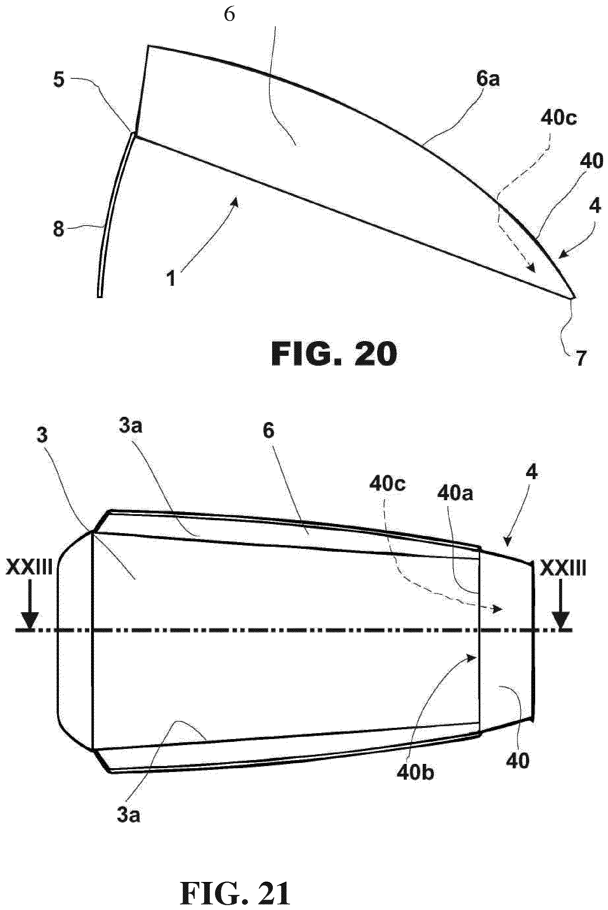

Figure 20 is a side view in elevation, of this shield bracket that allows you to appreciate your side profile and shape of its walls side screen.
Figure 21 is a top view, on the ground, of this shield bracket which shows the layout of the different walls from the main wall of support

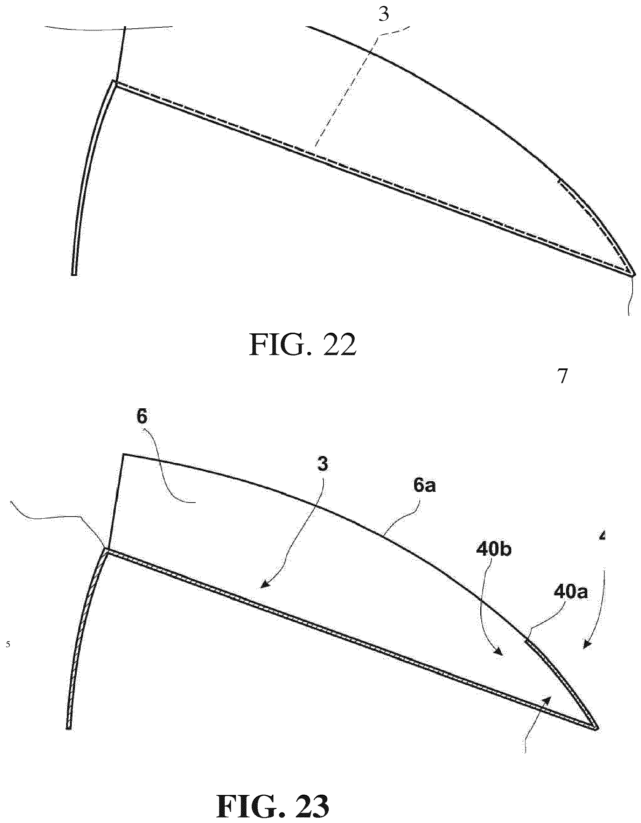

Figure 22 is a side view in elevation, of this shield bracket side screen walls added.
Figure 23 is a longitudinal cut of this shield bracket, according to a cutting plane which has been indicated as XXIII-XXIII in figure 21. 2

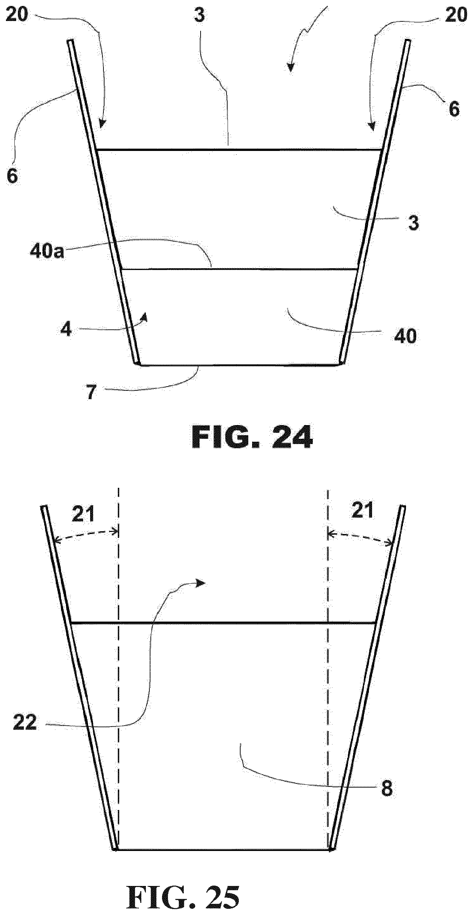

Figure 24 is a back view in elevation of this shield bracket.
Figure 25 is a previous view in previous perspective in elevation of this shield bracket.

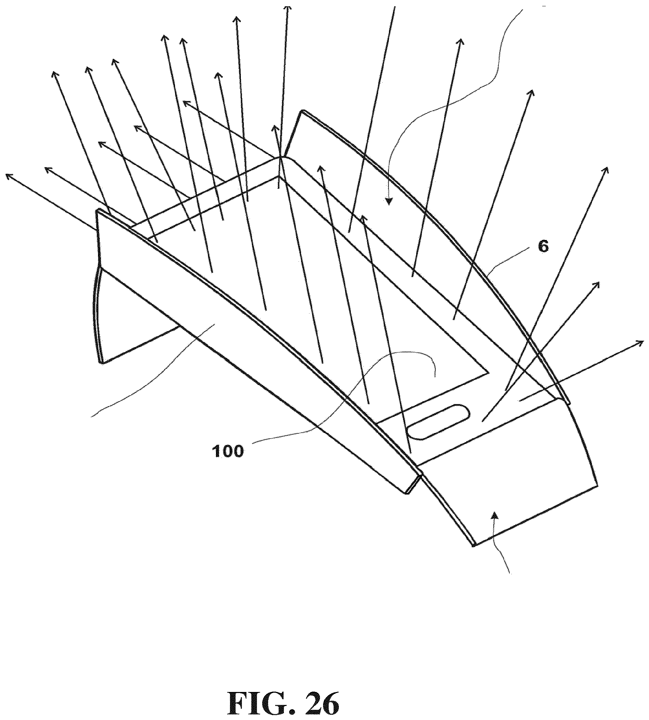

Figure 26 is a perspective view of this protective device on the main wall of support in which there is a communication device which emission of electromagnetic waves has been represented by arrows, except for an area protected by the aluminum walls of the structure.

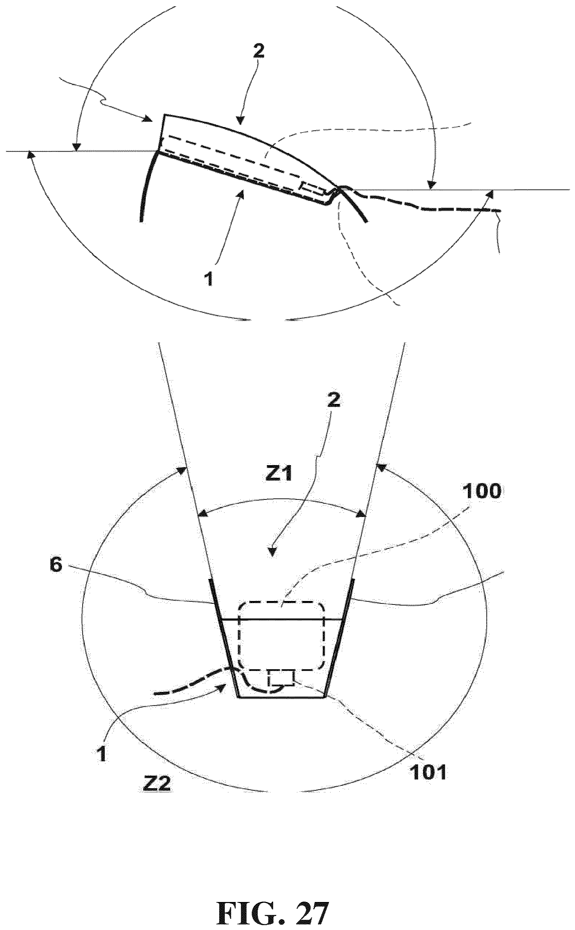

Figure 27 includes the drawings A, B, and C, being:
   The drawing A, a side view in elevation, of this shield bracket - a form of realization of the fig. 1-around which are indicated both the area of emission of the protection zone of electromagnetic waves of the communication device; and
   The drawing B, a rear view, in elevation, of this shield bracket around which are indicated both the area of emission of the protection zone of electromagnetic waves of the communication device.

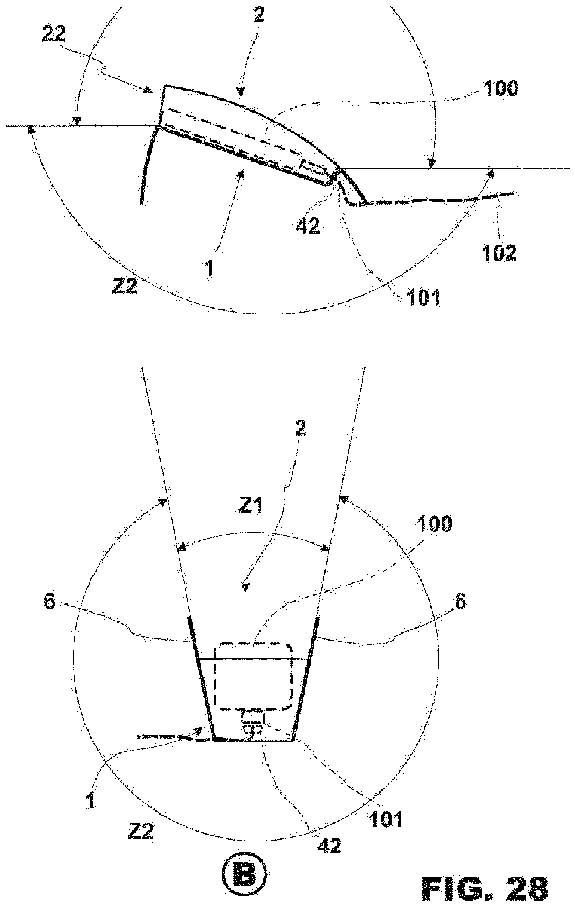

Figure 28 includes the drawings A, B, and C, being:
   The drawing A, a detail with a side view in elevation of this shield bracket form of implementation of the illustration 9- around which are indicated both the area of emission of the protection zone of electromagnetic waves of the communication device; and The drawing B, a rear view, in elevation, of this shield bracket around which are indicated both the area of emission of the protection zone of electromagnetic waves of the communication device.

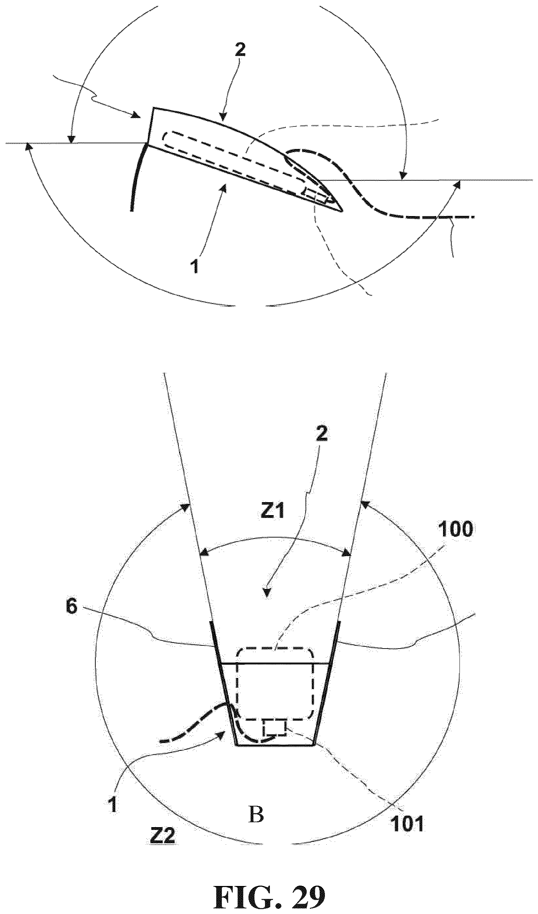

Figure 29 includes the drawings A, B, and C, being:
   The drawing A, a side view in elevation, of this shield bracket - an implementation of illustration 18- around which are indicated both the area of emission of the protection zone of electromagnetic waves of the communication device; and
   The drawing B, a rear view, in elevation, of this shield bracket around which are indicated both the area of emission of the protection zone of electromagnetic waves of the communication device.

In the different illustrations, the same numbers and/or letters of reference indicate equal parts or corresponding ones.

### List of the main references

(1) Support Structure. -
(2) Open enclosure.
(3) Main wall of support
(3a) Side Edges.
(4) Containment structure.
(40) Partial cover of boxing.
(40a) top edge of boxing.
(40b) Opening of boxing.
(40c) Cavity of crating.
(41) Extreme wall of complementary support.
(41a) Lower Limit or fold ascendant [of the extreme wall of support (41)].
(41b) Intermediate Sector in support of the [extreme wall of support (41)]. (41a) Upper Limit or fold ascendant [of the extreme wall of support (41)]. -
(42) Connection Passage
(5) Edge open.
(6) Side screen walls.
(6a) external edges or higher [the walls of side screen (6)].
(7) Smaller base.
(8) Bigger base
(20) Sides of manipulation.
(21) Divergence of the walls of side screen (6) [with regard to the main wall of support (3).
(22) Extreme opening.
(100) Communication Device [Sender of electromagnetic waves].
(101) Charging Connector.
(102) Power Cable from the connector (101).
(Z1) area of emission of electromagnetic waves [on the part of the Communication device (100)].
(Z2) Zone of protection of electromagnetic waves [issued by the device of communication (100)].

### Description

In general terms, the present utility model refers to a shield bracket of electromagnetic waves for communication devices that includes an open enclosure (2) delimited by a support structure (1) equipped with a main wall of support (3) and a containment structure (4), which is prepared to receive and serve as a support for communication devices (100), such as cell phones; the entire structure (1) or at least its walls of side screen (5), which are projected beyond the open enclosure (2), are structured in aluminum and therefore constitute barriers to the emission of electromagnetic waves coming from the devices (100) which support.

### Detailed Description:

This shield bracket serves both as a means of support, as of partial blockage of the emission of electromagnetic waves issued by communication devices (100), such as cell phones or laptops.

This shield bracket comprises a support structure (1) which walls define an open enclosure (2), capable of containing the device of communication (100) supported. Different spaces and/or openings of handling (20) (22) allow both support as well as how to get to the device of communication (100) from the referred to open enclosure (2).

More particularly, the support structure (1) comprises a main wall of support (3) delimited by an extreme edge (5), a containment structure (4) and a few side edges (3a).

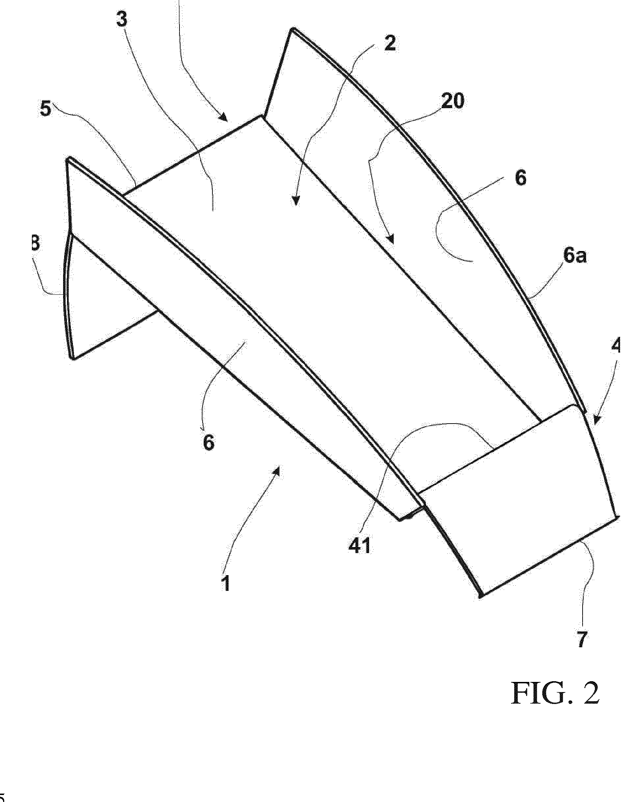

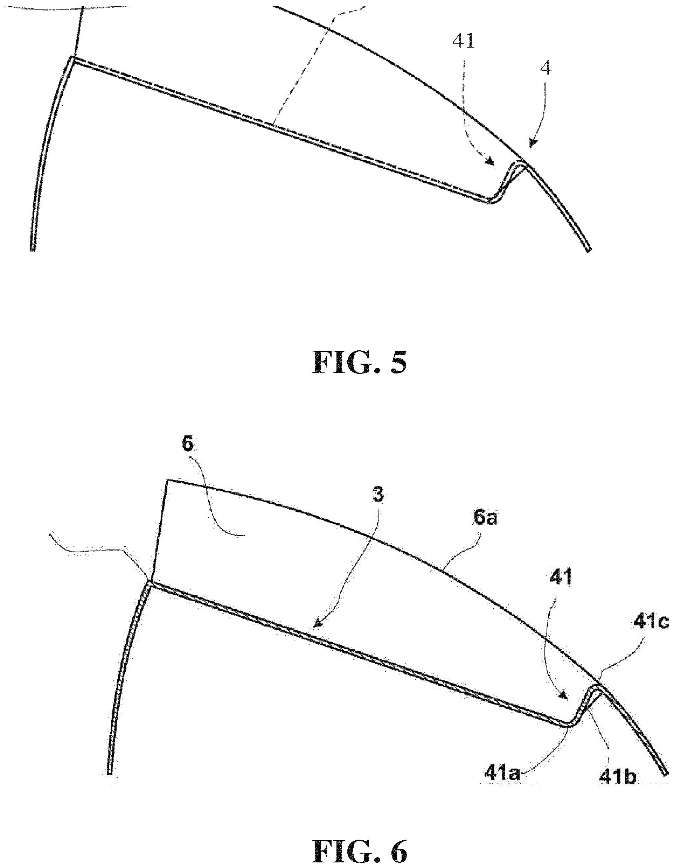

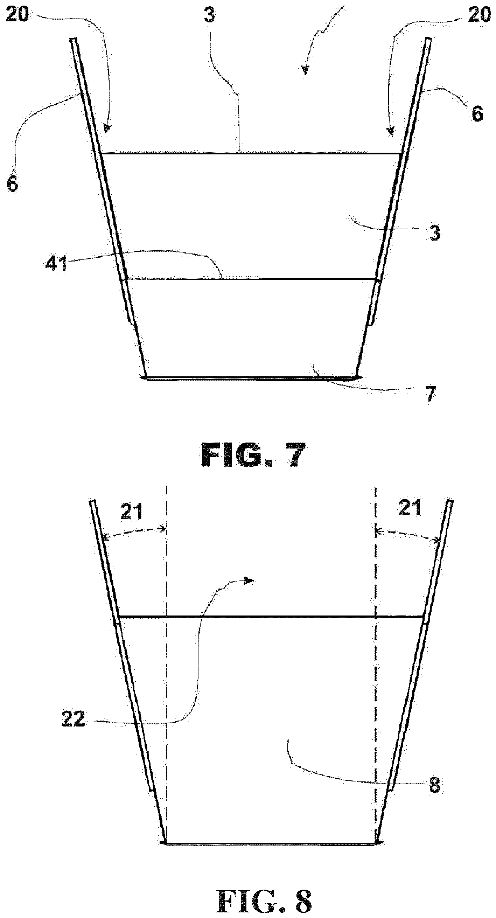

In a form of realization [See figures 1 to 8], the containment structure (4) comprises a main wall support (41) additional to complement the above-mentioned wall of support (3). This extreme wall (41) is defined by an intermediate sector of support (41b), which lower limit (41a) is adjacent to the main wall of support (3) and which upper limit (41c) is adjacent to a smaller base (7).

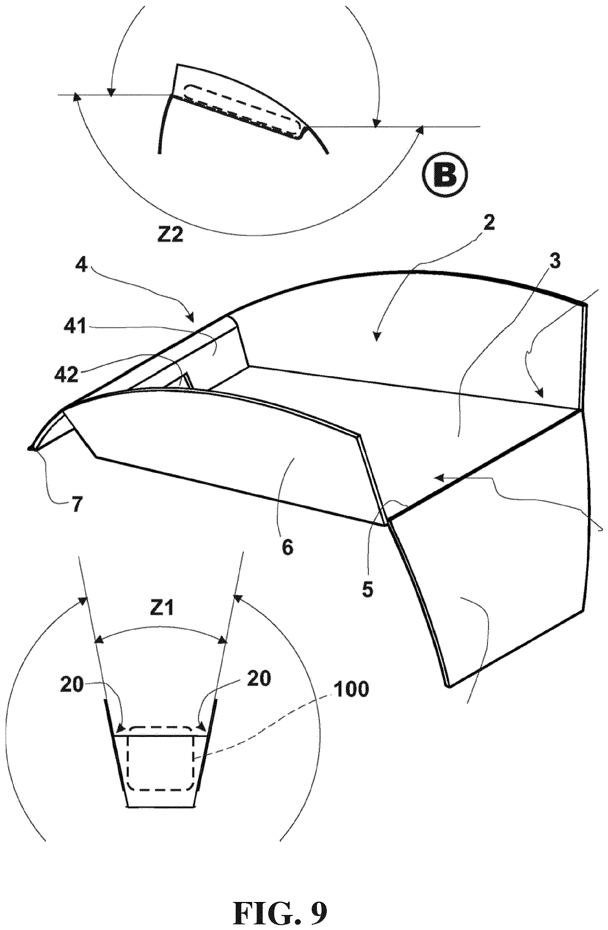

Preferably, the above-mentioned wall of support (3) presents a tilted slope towards the extreme wall of support (41) complementary which integrates the containment structure (4). In another form of presentation [See figures 9 to 17], provision has been made for the presence of, at least, a passage of connection (42) which allows the power cable (102) to enter into the open enclosure (2) through the support structure (1). In this case, the passage of connection (42) crosses the complementary wall support (41).

In another form of implementation [See Figures 19 to 25], the aforementioned main wall of support (3) also presents a tilted slope toward the bottom, where there is a containment structure (4) comprising at least a partial cover (40). This partial cover (40), along with the bottom of the main wall of support (3), composes a crating.

The above-mentioned crating delimits a receptacle or cavity of boxing-in (40c) capable of receiving and housing to the bottom of a phone (100) with its charging connector (101) which is connected. The cavity (40c) of the crating
has an opening (40b) that enables both the entrance of that telephone (100), as well as the output of an electrical power cord (102) corresponding to the charging connector (101).

Externally, the meeting area between the main wall of support (3) and the partial cover (40) form a smaller base (7).

In several forms of implementation, on the opposite side to the containment structure (4), there is a border open end (5), which extreme opening (22) allows the manipulation of the device (100) for that sector. In various ways of implementation, such extreme edge open (5) can be totally or partially open.

The fall or tilt of the main wall of support (3) is determined by the different height of the feet (7)(8) that extend as from the containment structure (4) and the extreme edge (5). Thus, while from the containment structure (4) there is a projection of the smaller base (7), from the edge open end (5) there is the projection of the bigger base (8).

Laterally, from the side edges (3a) of the main wall of support (3), there are projected paths walls of side screen (5), which height exceeds into the open enclosure (2) and is also greater than the height of any device of communication (100) which rests on the main wall of support (3).

On one hand, it is estimated that these walls of side screen (5) are projected divergently (21) with respect to the main wall of support (3), forming a lateral space manipulation (20) adjacent to the main wall (3) to facilitate the placement and removal of the device of communication (100). For example, the divergent projection (21) with respect to the main wall of support (3), you may have an angle which value appears within a range which minimum limit is 90° and which ceiling is 135°.

On the other hand, those walls of side screen (5) fulfill the function of barriers to the emission of electromagnetic waves on the part of the device of communication (100) housed in the open enclosure (2). In order to comply with such a role, they are structured in aluminum. Preferably, an aluminum of the 1000 series will be used, for example aluminum 1100. With regard to the thickness, although the same can be variable, it is estimated the possibility that you may have a value in a range which minimum limit is 1,2 mm and which maximum limit is 2.5 mm.

In addition to the presence of a suitable material to act as a barrier of emission, the possibility of some or all of this support walls have been foreseen to a cover that, in various ways of implementation, may include plastics, rubbers, paints, etc. These covers may fulfill different functions such as external protection, aesthetics termination, etc.

Taking into account the above-mentioned barrier function against the emission of waves, the height and inclination of the walls of side screen (5) - joint venture or interchangeably used- constitute adjustment variables of the protection space (Z2) adjacent side.

In a form of implementation, the top edges or external ones (6a) of the walls of side screen (5) will be convex, in such a way as to enhance protection in the central sector which is more prominent, but with a lower height of these walls of side screen (5) at the ends so as not to make it more difficult the handling in those sectors.

Although, at least the walls of side screen (5) must be structured in aluminum, the presence of this material - for example with the same specifications described - in all the walls (3) (40)(41)(6) of this support, will increase the function of protection and blocking of electromagnetic waves. Therefore, the present shield bracket may be partially or totally structured in aluminum.

Although the walls of side screen (5) can be added to be set to the side edges (3a) of the main wall of support (3), it is also estimated that this shield bracket is structured starting from a laminar sheet of aluminum formed.

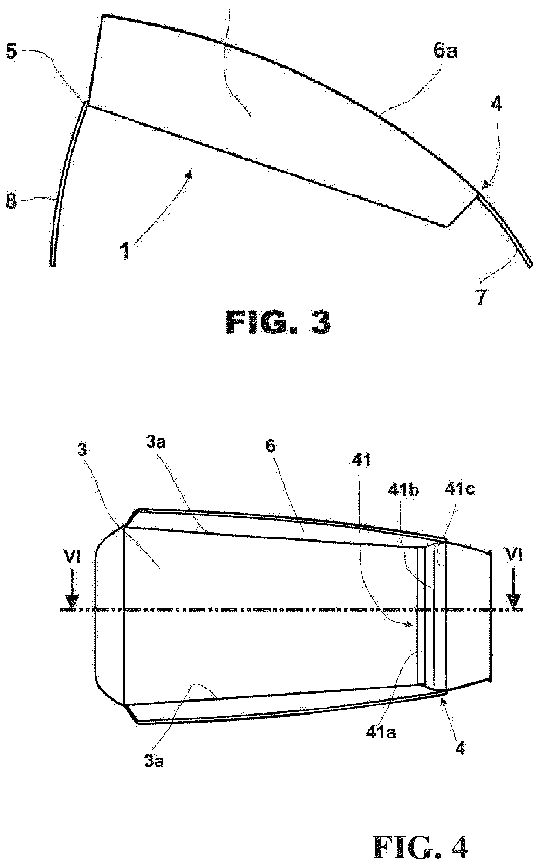

In the latter case, by lines of duplicity and folding there appears the main wall of support (3) inclined, from which edges (3a) (4)(5) two folds make up the rest of the walls (40) (41) (6)(7)(8). On one hand, from the lower edge (4), a fold upward (4a) form the middle sector (4b) to the main wall of support (4) complementary, followed by a retreat descending (4c) that forms the smaller base (7). On the other hand, from both side edges (3a), two ascending folds [which in this case are the side edges (3a)] are the corresponding walls of side screen (5). [See figures 3 to 6 and 12 to 15].

In another form of implementation [See Figures 20, 21, 22 and 23], from the top edge (5), a fold-down form the bigger base (8), while, as a possible variant, a retreat from the partial cover up of boxing (40).

In other forms of implementation, this shield bracket may comprise mounting means that allow linking to different structures, for example walls, furniture, etc.

It is also expected to be provided with the means of portable mounting for fixing temporary or transient in different structures such as cars or other means of transport. Thus, it will be able to use media portable mounting removable, magnet-type, with various media of fastening, etc.

### Operation of the set

The open enclosure (2) lets you easily put a device of communication (100) on the structure of support (1), in such a way that it lies resting on the main wall of support (3) and is included within the containment structure (4).

Under these conditions, the emission of electromagnetic waves is blocked by both the support structure (1) such as the walls of side screen (5) Structured in aluminum for what constitute barriers to the emission of electromagnetic waves.

Thus, this limits the emission zone (Z1) of these electromagnetic waves issued by the device of communication (100) and creates a wide area of the protection zone (Z2).

There is no doubt that the present utility model implemented, may introduce amendments to certain details of construction and refers to, without departing from the basic principles that are clearly substantiated in the claim clauses herein below:
Having thus been particularly described and determined the nature of this utility model, and how it can be implemented, it is stated to claim, as of the exclusive right and property:

## Claims

1. **SHIELD BRACKET OF ELECTROMAGNETIC WAVES FOR COMMUNICATION DEVICES,** this shield bracket serves both as a means of support, as of partial blockage of the emission of electromagnetic waves issued by communication devices, such as cell phones or laptops, including:
An open enclosure capable of containing the communication device supported,
- Such open enclosure includes openings in handling both to support as well as to get the communication device, portrayed because it comprises
- A main supporting wall,
- At least one containment structure that complements the main wall,
- At least, a set of walls of side screen projecting beyond the path open enclosure constituting barriers to the emission of electromagnetic waves and
- At least, those walls of side screen are structured in aluminum.

2. **SHIELD BRACKET OF ELECTROMAGNETIC WAVES FOR COMMUNICATION DEVICES,** according to claim 1, portrayed because the containment structure comprises at least one wall of complementary support to supplement the main wall of support.

3. **SHIELD BRACKET OF ELECTROMAGNETIC WAVES FOR COMMUNICATION DEVICES,** according to claim 1, portrayed because it constitutes:
- A main wall of support with slope toward a containment structure that is complementary to the main wall of support,
- A opposite edge opens for handling,
- A set of side shields that are projected beyond the open enclosure and
- At least, these side shields are structured in aluminum.

4. **SHIELD BRACKET OF ELECTROMAGNETIC WAVES FOR COMMUNICATION DEVICES,** according to the claim 1, portrayed because it is, at least partially, structured in aluminum.

5. **SHIELD BRACKET OF ELECTROMAGNETIC WAVES FOR COMMUNICATION DEVICES,** according to the claim 1, portrayed because it is totally structured in aluminum.

6. **SHIELD BRACKET OF ELECTROMAGNETIC WAVES FOR COMMUNICATION DEVICES,** according to the claims 1, portrayed because it comprises an aluminum of the 1000 series.

7. **SHIELD BRACKET OF ELECTROMAGNETIC WAVES FOR COMMUNICATION DEVICES,** according to the claim 7, portrayed because it comprises an aluminum 1100.

8. **SHIELD BRACKET OF ELECTROMAGNETIC WAVES FOR COMMUNICATION DEVICES.** According to claim 1, portrayed because it is, at least partially, structured in aluminum walls whose thickness is of a value within a range which minimum limit is 1.2 mm and which maximum limit is 2.5 mm.

9. **SHIELD BRACKET OF ELECTROMAGNETIC WAVES FOR COMMUNICATION DEVICES,** according to claim 1, portrayed because it is structured from a laminar sheet of aluminum which lines of duplicity and folding constitute:
- A main wall of support inclined, from which edges of two separate folding create the rest of the walls,
- From the top edge, a designed fold-down form a foot higher,
- From the bottom edge, at least, a fold up forms a structure of contention and a lower base and
- From both side edges, two ascending folds form corresponding walls of side screen.

10. **SHIELD BRACKET OF ELECTROMAGNETIC WAVES FOR COMMUNICATION DEVICES,** according to claim 9, portrayed from the bottom edge, an ascending fold-up forms a wall of complementary support, followed by a retreat that creates a lower base.

11. **SHIELD BRACKET OF ELECTROMAGNETIC WAVES FOR COMMUNICATION DEVICES,** according to claim 1, portrayed because the containment structure lateral is set, at least, to the lateral side borders of the main walls.

12. **SHIELD BRACKET OF ELECTROMAGNETIC WAVES FOR COMMUNICATION DEVICES,** according to claim 1, portrayed because the walls of side screen divergently project in relation to the main wall of support, forming a lateral space of handling adjacent to the main wall.

13. **SHIELD BRACKET OF ELECTROMAGNETIC WAVES FOR COMMUNICATION DEVICES,** in accordance with claim 12, portrayed because the walls of side screen are divergently projected on the main wall of support, with an angle which value appears within a range which minimum limit is 93° and which maximum limit is 130°.

14. **SHIELD BRACKET OF ELECTROMAGNETIC WAVES FOR COMMUNICATION DEVICES,** according to claim 1, portrayed because the superior edges of lateral screen walls are convex.

15. **SHIELD BRACKET OF ELECTROMAGNETIC WAVES FOR COMMUNICATION DEVICES,** according to claim 1, portrayed because, either jointly or interchangeably, the height and tilt of the walls of side screen are variables of adjustment of the adjacent side of the protection zone.

16. **SHIELD BRACKET OF ELECTROMAGNETIC WAVES FOR COMMUNICATION DEVICES,** in accordance with claim 15, portrayed because the inclination of the main wall of support is determined by the different height of the feet.

17. **SHIELD BRACKET OF ELECTROMAGNETIC WAVES FOR COMMUNICATION DEVICES** according to claim 1, portrayed because the containment structure comprises at least a partial coverage that composes a crating with the main wall of support.

18. **SHIELD BRACKET OF ELECTROMAGNETIC WAVES FOR COMMUNICATION DEVICES,** in accordance with claim 17, portrayed because the crating delimits a receptacle capable of receiving and housing to the bottom of a phone with its charging device connected, while the opening of the crating enables both the entrance of that telephone as the output of an appropriate cable to such charging connector.

19. **SHIELD BRACKET OF ELECTROMAGNETIC WAVES FOR COMMUNICATION DEVICES,** according to claim 1, portrayed because it comprises means of portable adjustment.

20. **SHIELD BRACKET OF ELECTROMAGNETIC WAVES FOR COMMUNICATION DEVICES,** according to claim 19, portrayed because the portable adjustment means are movable.

21. **SHIELD BRACKET OF ELECTROMAGNETIC WAVES FOR COMMUNICATION DEVICES,** according to claim 19, portrayed because the portable adjustment means comprises means of magnetic fixation.

22. **SHIELD BRACKET OF ELECTROMAGNETIC WAVES FOR COMMUNICATION DEVICES,** according to claim 19, portrayed because the means of portable fixation comprise adjustment means.

23. **SHIELD BRACKET OF ELECTROMAGNETIC WAVES FOR COMMUNICATION DEVICES,** according to claim 1, portrayed because they comprise fixation means suitable to different building structures and/or vehicles.

24. **SHIELD BRACKET OF ELECTROMAGNETIC WAVES FOR COMMUNICATION DEVICES,** according to claim 1, portrayed because part of the walls comprises a superficial cover.
